# EUROPEAN PATENT APPLICATION

(11) **EP 4 420 540 A1**
(43) Date of publication of application: **28.08.2024**
(21) Application number: 21961302.3
(22) Date of filing: 18.10.2021
(51) Int. Cl.: A24F 40/40

(54) **NON-COMBUSTION-HEATING-TYPE FLAVOR INHALER**

(71) Applicant: Japan Tobacco Inc., Tokyo 105-6927 (JP)
(72) Inventor: TSUKUI, Satomi, Tokyo 130-8603 (JP); NAGASE, Ryosuke, Tokyo 130-8603 (JP)
(74) Representative: Hoffmann Eitle
(86) International application number: PCT/JP2021/038402
(87) International publication number: WO 2023/067648

(57) **Abstract**

Provided is a non-combustion-heating-type flavor inhaler in which a flavor molded body can be fixed in position during use and from which the flavor molded body can be easily removed after use. A non-combustion-heating-type flavor inhaler comprising: a flavor molded body including a tobacco powder raw material, an aerosol source, and a magnet or a magnet adsorption material that adsorbs the magnet using magnetic force; a flavor molded body accommodation part for accommodating the flavor molded body; a power supply unit provided with a power supply part; a first heating unit for receiving a supply of electric power from the power supply part and generating heat; and a heat-transmitting member provided on the inner wall of the flavor molded body accommodation part, the heat-transmitting member transmitting heat from the first heating part to the flavor molded body, wherein: the heat-transmitting member includes the magnet adsorption material if the flavor molded body includes the magnet, and includes the magnet if the flavor molded body includes the magnet adsorption material; and according to a prescribed method, the tensile force measured in the magnet when the magnet is heated to 140°C is 95% or less of the tensile force measured in the magnet at 20°C.

## Description

### TECHNICAL FIELD

The present invention relates to a non-combustion-heating-type flavor inhaler.

### BACKGROUND ART

A combustion-type flavor inhaler (cigarette) generates a flavor through combustion of a tobacco filler containing leaf tobacco. As an alternative of the combustion-type flavor inhaler, there has been proposed a non-combustion-heating-type flavor inhaler that generates a flavor by heating a flavor source containing a tobacco material instead of burning the flavor source. The heating temperature of the non-combustion-heating-type flavor inhaler is lower than the combustion temperature of the combustion-type flavor inhaler and is, for example, about 400°C or lower. Since the heating temperature of the non-combustion-heating-type flavor inhaler is low as mentioned above, an aerosol source, such as glycerine, is added to a flavor source in the non-combustion-heating-type flavor inhaler in order to increase the amount of smoke. The aerosol source is vaporized by being heated and generates an aerosol. The aerosol is supplied to a user together with a flavor component, such as a tobacco component, and thus, the user can obtain a sufficient flavor.

An example of a flavor source of the non-combustion-heating-type flavor inhaler is a tablet-shaped flavor molded body. If the flavor molded body maintains its shape without deformation through heating and is likely to keep the user's fingers clean even when it is pinched by them, the flavor molded body can be used by being introduced into a flavor molded body accommodation part of the non-combustion-heating-type flavor inhaler as is without being accommodated in a pod container or the like.

In PTL 1, it is described that, in a modularized vaporizer, a magnet can be provided at each inner surface of a fuel module chamber and each inner surface of a heating module chamber. It is also described that surfaces of a fuel module and a heating module that come into contact with the magnets can be made of a material that is attracted to magnets, or magnets can be attached to these surfaces so that the fuel module and the heating module are respectively fixed to the fuel module chamber and the heating module chamber by magnetic force. In PTL 2, it is described that, in an aerosol generating device, at least one of a base portion of an elongated susceptor element and a magnetic element that is disposed in a housing includes a permanent magnet. It is also described that the magnetic attraction force between the base portion and the magnetic element enables the elongated susceptor element to be removably attached a closed end of a chamber.

### CITATION LIST

### PATENT LITERATURE

PTL 1: Japanese Unexamined Patent Application Publication No. 2019-527049
PTL 2: Japanese Unexamined Patent Application Publication No. 2020-529852

### SUMMARY OF INVENTION

### TECHNICAL PROBLEM

As mentioned above, in the case where the flavor molded body is used as is by being introduced into the flavor molded body accommodation part of the non-combustion-heating-type flavor inhaler, the flavor molded body needs to be fixed in position in the flavor molded body accommodation part so that heat from a heater is transmitted to the flavor molded body with certainty. Although the flavor molded body needs to be fixed in position during use of the non-combustion-heating-type flavor inhaler as mentioned above, it is desirable that the flavor molded body can be easily taken out of the non-combustion-heating-type flavor inhaler after use.

It is an object of the present invention to provide a non-combustion-heating-type flavor inhaler in which a flavor molded body can be fixed in position in a flavor molded body accommodation part during use and from which the flavor molded body can be easily removed after use.

### SOLUTION TO PROBLEM

The present invention includes an aspect described below.
[1] A non-combustion-heating-type flavor inhaler including:
   a flavor molded body including a tobacco powder raw material, an aerosol source, and a magnet or a magnetically attracting material that is to be held on the magnet using magnetic force;
   a flavor molded body accommodation part that accommodates the flavor molded body;
   a power supply unit including a power supply;
   a first heater that generates heat by receiving electric power supplied by the power supply; and
   a heat-transmitting member that is provided on an inner wall of the flavor molded body accommodation part and that transmits heat from the first heater to the flavor molded body,

The heat-transmitting member includes the magnetically attracting material when the flavor molded body includes the magnet, and the heat-transmitting member includes the magnet when the flavor molded body includes the magnetically attracting material.

In a magnetic force measurement method described below, a magnetic attraction force of the magnet measured when the magnet is heated to 140°C is 95% or less of a magnetic attraction force of the magnet measured when the magnet is at 20°C.

### (Magnetic Force Measurement Method)

A force gauge in which a disc member made of iron is attached to a tip of a measurement part is prepared, and a cylindrical magnet having a diameter of 6 mm and a thickness of 2 mm is held on the disc member using magnetic force. The force gauge is fixed in position such that the magnet is located on a lower side, and the magnet is pulled downward. A magnetic attraction force (N) when the magnet is detached from the disc member is measured. The measurement is performed three times, and an average of three measured values is taken as the magnetic attraction force. The measurement is performed on the magnet that is at 20°C and on the magnet that is heated to 140°C.

[2] In the non-combustion-heating-type flavor inhaler according to [1], in the magnetic force measurement method, the magnetic attraction force of the magnet measured when the magnet is heated to 140°C is 70% or less of the magnetic attraction force of the magnet measured when the magnet is at 20°C.

[3] In the non-combustion-heating-type flavor inhaler according to [1] or [2], when the magnetic attraction force is measured again by the magnetic force measurement method after the magnet heated to 140°C has been cooled to 20°C, the magnetic attraction force is 95% or less of the magnetic attraction force of the magnet measured when the magnet has not yet been heated and is at 20°C.

[4] In the non-combustion-heating-type flavor inhaler according to [3], when the magnetic attraction force is measured again by the magnetic force measurement method after the magnet heated to 140°C has been cooled to 20°C, the magnetic attraction force is 70% or less of the magnetic attraction force of the magnet measured when the magnet has not yet been heated and is at 20°C.

[5] In the non-combustion-heating-type flavor inhaler according to any one of [1] to [4], the flavor molded body includes the magnet, and the heat-transmitting member includes the magnetically attracting material.

[6] The non-combustion-heating-type flavor inhaler according to any one of [1] to [5] further includes a flavor molded body collecting part that collects the flavor molded body that has been heated by the heat-transmitting member.

[7] In the non-combustion-heating-type flavor inhaler according to [6], the flavor molded body collecting part is disposed at a position facing the heat-transmitting member.

[8] In the non-combustion-heating-type flavor inhaler according to [6] or [7], the flavor molded body collecting part includes a second heater that heats the flavor molded body.

### ADVANTAGEOUS EFFECTS OF INVENTION

According to the present invention, a non-combustion-heating-type flavor inhaler in which a flavor molded body can be fixed in position in a flavor molded body accommodation part during use and from which the flavor molded body can be easily removed after use can be provided.

### BRIEF DESCRIPTION OF DRAWINGS

[Fig. 1] Fig. 1 is a schematic diagram illustrating an example of a non-combustion-heating-type flavor inhaler according to an embodiment.
[Fig. 2] Fig. 2 is a schematic diagram illustrating another example of the non-combustion-heating-type flavor inhaler according to the present embodiment.
[Fig. 3] Fig. 3 is a schematic diagram illustrating an example of arrangement of magnets of a flavor molded body according to the present embodiment.
[Fig. 4] Fig. 4 is a schematic diagram illustrating a magnetic force measurement method in Example.

### DESCRIPTION OF EMBODIMENTS

A non-combustion-heating-type flavor inhaler according to the present embodiment includes a flavor molded body, a flavor molded body accommodation part, a power supply unit, a first heater, and a heat-transmitting member. The flavor molded body includes a tobacco powder raw material, an aerosol source, and a magnet or a magnetically attracting material that is to be held on the magnet using magnetic force. In other words, the flavor molded body includes the tobacco powder raw material, the aerosol source, and the magnet or includes the tobacco powder raw material, the aerosol source, and the magnetically attracting material. The flavor molded body accommodation part accommodates the flavor molded body. The power supply unit includes a power supply. The first heater generates heat by receiving electric power supplied by the power supply. The heat-transmitting member is provided on an inner wall of the flavor molded body accommodation part and transmits heat from the first heater to the flavor molded body. In addition, the heat-transmitting member includes the magnetically attracting material in the case where the flavor molded body includes the magnet, and the heat-transmitting member includes the magnet in the case where the flavor molded body includes the magnetically attracting material. Here, the magnetic attraction force of the magnet measured by the magnetic force measurement method, which will be described below, when the magnet is heated to 140°C is 95% or less of the magnetic attraction force of the magnet measured when the magnet is at 20°C.

### (Magnetic Force Measurement Method)

A force gauge in which a disc member made of iron is attached to the tip of a measurement part is prepared, and a cylindrical magnet having a diameter of 6 mm and a thickness of 2 mm is held on the disc member using magnetic force. The force gauge is fixed in position such that the magnet is located on the lower side, and the magnet is pulled downward. A magnetic attraction force (N) when the magnet is detached from the disc member is measured. The measurement is performed three times, and the average of three measured values is taken as the magnetic attraction force. The measurement is performed on the magnet that is at 20°C and on the magnet that is heated to 140°C.

In the non-combustion-heating-type flavor inhaler according to the present embodiment, the flavor molded body includes the magnet or the magnetically attracting material in addition to the tobacco powder raw material and the aerosol source. In addition, the heat-transmitting member provided on the inner wall of the flavor molded body accommodation part includes the magnetically attracting material in the case where the flavor molded body includes the magnet, and the heat-transmitting member includes the magnet in the case where the flavor molded body includes the magnetically attracting material. As a result, the flavor molded body introduced in the flavor molded body accommodation part is held on the heat-transmitting member, which is provided on the inner wall of the flavor molded body accommodation part, by the magnetic force, so that the flavor molded body is fixed in position on the heat-transmitting member. Therefore, when the non-combustion-heating-type flavor inhaler according to the present embodiment is used, the heat-transmitting member heated by the heat from the first heater can sufficiently transmit heat to the flavor molded body fixed in position on the heat-transmitting member, and the aerosol source and a flavor component, such as a tobacco component, can be sufficiently vaporized from the flavor molded body.

In addition, regarding a magnet that is used as the magnet in the non-combustion-heating-type flavor inhaler according to the present embodiment, the magnetic attraction force of the magnet measured by the magnetic force measurement method when the magnet is heated to 140°C is 95% or less of the magnetic attraction force of the magnet measured when the magnet is at 20°C. Consequently, when the flavor molded body is sufficiently heated as the non-combustion-heating-type flavor inhaler is used over time, the magnetic force of the magnet decreases, resulting in reduced adhesion strength between the magnet and the heat-transmitting member. Thus, the flavor molded body may easily be detached from the heat-transmitting member, and the flavor molded body can be easily removed from the flavor molded body accommodation part after use of the non-combustion-heating-type flavor inhaler.

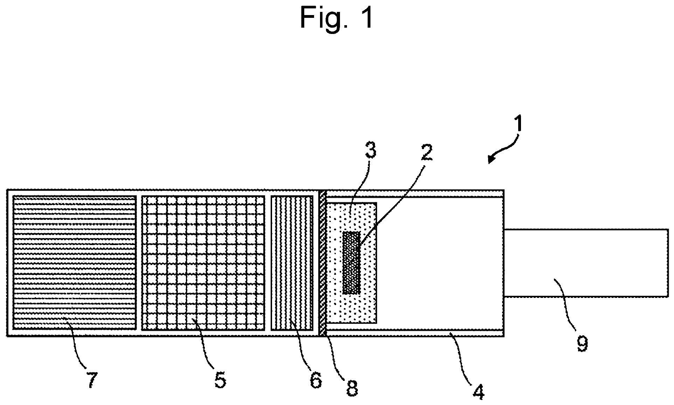

An example of the non-combustion-heating-type flavor inhaler according to the present embodiment is illustrated in Fig. 1. A non-combustion-heating-type flavor inhaler 1 illustrated in Fig. 1 includes a flavor molded body 3, a flavor molded body accommodation part 4, a power supply unit 5, a first heater 6, a controller 7, a plate-shaped heat-transmitting member 8, and a mouthpiece 9. The flavor molded body 3 includes a magnet 2 therein. The flavor molded body accommodation part 4 accommodates the flavor molded body 3. The power supply unit 5 includes a power supply. The first heater 6 generates heat by receiving electric power from the power supply of the power supply unit 5. The controller 7 controls the temperature of the first heater 6. The heat-transmitting member 8 is provided on an inner wall of the flavor molded body accommodation part 4 and includes a magnetically attracting material. The heat-transmitting member 8 transmits heat from the first heater 6 to the flavor molded body 3.

The flavor molded body 3 that is introduced into the flavor molded body accommodation part 4 through a flavor molded body inlet (not illustrated) is held on the heat-transmitting member 8, which includes the magnetically attracting material, by the magnetic force of the magnet 2. Upon start of the use of the non-combustion-heating-type flavor inhaler 1, electric power is supplied from the power supply of the power supply unit 5 to the first heater 6 in response to an instruction from the controller 7, so that the first heater 6 is heated. The heat of the first heater 6 is transmitted to the heat-transmitting member 8 and is further transmitted to the flavor molded body 3 held on the heat-transmitting member 8, so that the flavor molded body 3 is heated. By heating the flavor molded body 3, the aerosol source and the flavor component, such as a tobacco component, included in the flavor molded body 3 are vaporized, and an aerosol containing the flavor component is generated. The aerosol is inhaled by a user through the mouthpiece 9, so that the aerosol and the flavor component are supplied to the user. The heating temperature is preferably 130°C to 400°C and more preferably 200°C to 350°C. Note that the heating temperature is the temperature of the first heater 6.

On the other hand, the temperature of the flavor molded body 3 gradually increases during use, reaching a temperature close to the heating temperature of the first heater 6 by the end of use of the non-combustion-heating-type flavor inhaler 1. Here, regarding the magnet 2, the magnetic attraction force of the magnet 2 measured by the above-described magnetic force measurement method when the magnet 2 is heated to 140°C is 95% or less of the magnetic attraction force of the magnet 2 measured when the magnet 2 is at 20°C, and thus, the magnetic adhesion strength of the flavor molded body 3 with respect to the heat-transmitting member 8 is reduced at the end of the use. Accordingly, detaching the flavor molded body 3 from the heat-transmitting member 8 becomes easier than before use, and the flavor molded body 3 can be easily taken out of the flavor molded body accommodation part 4 after use. Note that Fig. 1 illustrates the case where the flavor molded body 3 includes the magnet 2 and where the heat-transmitting member 8 includes the magnetically attracting material. However, the flavor molded body 3 may include the magnetically attracting material and the heat-transmitting member 8 may include the magnet 2.

In the present embodiment, the magnetic attraction force of the magnet measured by the above-described magnetic force measurement method when the magnet is heated to 140°C is 95% or less of the magnetic attraction force of the magnet measured when the magnet is at 20°C. The type of such a magnet is not particularly limited, and examples thereof include a neodymium magnet, a ferrite magnet, a samarium-cobalt magnet, and an alnico magnet. These magnets may be used alone or may be used in combination of two or more. Among these magnets, a neodymium magnet that has a Curie temperature of about 330°C, which is relatively low, is more preferable. The magnetically attracting material is not particularly limited as long as it is a material that is held on the magnet using magnetic force, and examples thereof include iron, nickel, and cobalt. These magnetically attracting materials may be used alone or may be used in combination of two or more. In order to make it easier to remove the flavor molded body after use, the magnetic attraction force of the magnet measured by the above-described magnetic force measurement method when the magnet is heated to 140°C is preferably 70% or less, more preferably 50% or less, and further preferably 30% or less of the magnetic attraction force of the magnet measured when the magnet is at 20°C. Note that, although the lower limit of the above range is not particularly limited, it can be, for example, 10% or more.

In the present embodiment, when the magnetic attraction force is measured again by the magnetic force measurement method after the magnet heated to 140°C has been cooled to 20°C, the magnetic attraction force is preferably 95% or less of the magnetic attraction force of the magnet measured when the magnet has not yet been heated and is at 20°C. As described above, when the magnetic attraction force of the magnet that is heated to 140°C and then cooled to 20°C is 95% or less of the magnetic attraction force of the magnet that has not yet been heated and is at 20°C, the magnetic force does not return to the magnetic force before heating despite a decrease in the temperature of the magnet after use. Thus, the flavor molded body can be more easily removed after use. In addition, the flavor molded body can be sufficiently cooled before taking it out. The type of such a magnet is not particularly limited, and examples thereof include a neodymium magnet, a ferrite magnet, a samarium-cobalt magnet, and an alnico magnet. These magnets may be used alone or may be used in combination of two or more. When the magnetic attraction force is measured again by the magnetic force measurement method after the magnet heated to 140°C has been cooled to 20°C, the magnetic attraction force is more preferably 70% or less, still more preferably 50% or less, and particularly preferably 30% or less of the magnetic attraction force with respect the magnet measured when the magnet has not yet been heated and is at 20°C. Note that, although the lower limit of the above range is not particularly limited, it can be, for example, 10% or more.

In the present embodiment, when the flavor molded body includes the magnet, the heat-transmitting member includes the magnetically attracting material, and when the flavor molded body includes the magnetically attracting material, the heat-transmitting member includes the magnet. However, it is preferable that the flavor molded body include the magnet and that the heat-transmitting member include the magnetically attracting material. This is because, as described above, in the case where the magnet is a magnet whose magnetic force does not return to its original magnetic force when it is cooled after being heated, if the magnet is used in the heat-transmitting member, its magnetic force will decrease due to repeated use, and thus, a sufficient adhesion strength between the magnet and the flavor molded body may sometimes not be obtained.

It is preferable that the non-combustion-heating-type flavor inhaler according to the present embodiment further include a flavor molded body collecting part that collects the flavor molded body after being heated by the heat-transmitting member. The used flavor molded body detached from the heat-transmitting member is collected into the flavor molded body collecting part, so that the used flavor molded body can be easily taken out. In addition, the flavor molded body can be prevented from being overheated by the heat-transmitting member, and as will be described later, the flavor molded body can also be reheated in the flavor molded body collecting part.

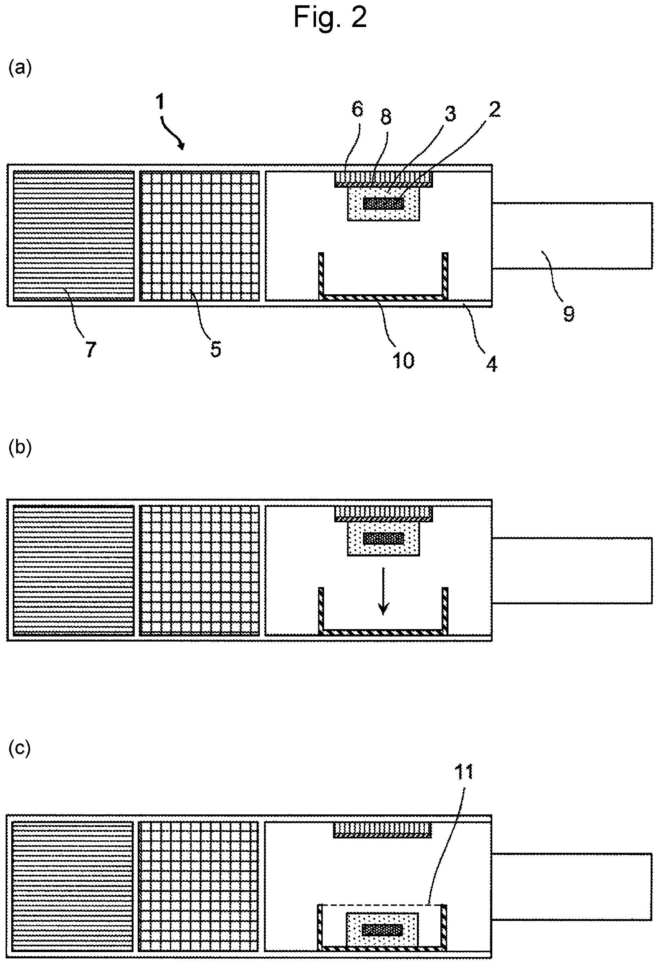

Fig. 2(a) illustrates another example of the non-combustion-heating-type flavor inhaler according to the present embodiment. In the non-combustion-heating-type flavor inhaler 1 illustrated in Fig. 2(a), the first heater 6 is provided at an upper surface of the flavor molded body accommodation part 4, and the plate-shaped heat-transmitting member 8 is disposed on the first heater 6. In addition, a flavor molded body collecting part 10 that has a mesh structure and that is capable of accommodating the flavor molded body is provided at a position on a lower surface of the flavor molded body accommodation part 4, the position facing the heat-transmitting member 8. The flavor molded body 3 that is introduced into the flavor molded body accommodation part 4 through the flavor molded body inlet (not illustrated) is held on the heat-transmitting member 8, which includes the magnetically attracting material, by the magnetic force of the magnet 2 and heated by the heat-transmitting member 8. When the temperature of the flavor molded body 3 is sufficiently increased, the adhesion strength of the flavor molded body 3 with respect to the heat-transmitting member 8 obtained by the magnetic force of the magnet 2 is reduced, and as illustrated in Fig. 2(b), the flavor molded body 3 falls into the flavor molded body collecting part 10 and is collected into the flavor molded body collecting part 10.

In the non-combustion-heating-type flavor inhaler 1 illustrated in Fig. 2(a), a guide can be provided such that the heat-transmitting member 8 is located on the upper side and such that the flavor molded body collecting part 10 is located on the lower side when the non-combustion-heating-type flavor inhaler 1 is used. Examples of providing such a guide include providing a display on a surface of the non-combustion-heating-type flavor inhaler 1 that is located on the side on which the heat-transmitting member 8 is disposed, the display indicating that the non-combustion-heating-type flavor inhaler 1 is to be used with the surface facing upward, forming the mouthpiece 9 into a shape that can only be held in a mouth in a specific direction, positioning the power supply unit 5 closer to the flavor molded body collecting part 10 (the power supply unit 5 occupies most of the weight of the non-combustion-heating-type flavor inhaler 1, and thus, the center of gravity is inclined toward the side where the power supply unit 5 is disposed). In addition, a guide path may be provided so as to guide the flavor molded body 3 to the flavor molded body collecting part 10 through the guide path.

As illustrated in Fig. 2(c), it is preferable that the flavor molded body collecting part 10 include a shutter 11 that is openable and closable and that is provided at an opening thereof. By providing the shutter 11, the collected flavor molded body 3 can be prevented from coming out of the flavor molded body collecting part 10 again. For example, the shutter 11 can close upon detecting entry of the flavor molded body 3 into the flavor molded body collecting part 10. In such a mechanism, detecting the entry of the flavor molded body 3 into the flavor molded body collecting part 10 also enables a user to determine that the end of the use of the flavor molded body 3. In addition, the shutter 11 may close upon, for example, detecting a vertical orientation of the non-combustion-heating-type flavor inhaler 1. The shutter 11 may have a mesh structure. The flavor molded body collecting part 10 may also have a flavor molded body outlet through which the flavor molded body 3 can be taken out of the non-combustion-heating-type flavor inhaler 1.

In the present embodiment, it is preferable that the flavor molded body collecting part include a second heater that heats the flavor molded body. When the flavor molded body collecting part includes the second heater, the flavor molded body is rapidly heated by the heat from the first heater when the flavor molded body is magnetically held on the heat-transmitting member, and even after the flavor molded body has been detached from the heat-transmitting member and collected in the flavor molded body collecting part, the flavor molded body can be slowly heated by the second heater. In this manner, heating is also performed in the flavor molded body collecting part, so that the flavor molded body can generate an aerosol and the flavor component also in the flavor molded body collecting part, and the flavor molded body can be prevented from being overheated by the heat from the first heater. When the flavor molded body collecting part includes the second heater, the heating temperature by the second heater can be lower than the heating temperature by the first heater. For example, the heating temperature by the first heater is preferably 140°C to 400°C and more preferably 300°C to 350°C. The heating temperature by the second heater is preferably 40°C to 300°C and more preferably 40°C to 250°C.

In the present embodiment, the flavor molded body includes the tobacco powder raw material, the aerosol source, and the magnet or the magnetically attracting material. In addition to these, the flavor molded body can include, for example, a volatile flavor component, an adsorbent, cellulose powder, and so forth.

Examples of the tobacco powder raw material include powders obtained by, for example, cutting leaf tobacco, tobacco leaf veins, stems, roots, flowers, and the like. The leaf tobacco is not limited to a particular type, and examples of the type of the leaf tobacco include yellow varieties, Burley varieties, local varieties, oriental leaves, and fermented leaves of these. These tobacco powder raw materials may be used alone or may be used in combination of two or more.

Although the average particle diameter of the tobacco powder raw material is not particularly limited, it is preferably 100 µm or less. By setting the average particle diameter to be 100 µm or less, a flavor molded body having higher strength can be obtained. The average particle diameter is preferably 5 µm to 80 µm, more preferably 10 µm to 60 µm, and still more preferably 20 µm to 50 µm. Note that the average particle diameter is measured by using a light scattering method.

Examples of the aerosol source include glycerin and propylene glycol. These aerosol sources may be used alone or may be used in combination of two or more. The amount of the aerosol source included in the flavor molded body is preferably 5 parts by mass to 30 parts by mass and more preferably 10 parts by mass to 20 parts by mass relative to 100 parts by mass of the tobacco powder raw material.

Examples of the volatile flavor component include, but are not particularly limited to, phenethyl acetate, ethyl hexanate, isoamyl acetate, benzyl acetate, ethyl octanate, ethyl oleate, phenethyl alcohol, acetanisole, benzaldehyde, benzyl alcohol, menthol, carvone, cinnamic acid, cinnamaldehyde, cinnamyl alcohol, vanillin, ethyl vanillin, citronellol, 2,5-dimethylpyrazine, limonene, furaneol, cyclotene, decanoic acid, ethyl isovalerate, valeric acid, palmitic acid, ethyl salicylate, geraniol, guaiacol, β-ionone, linalool, linalyl acetate, nerolidol, piperonal, sotolon, α-terpineol, megastigmatrienone, damascenone, and neophytadiene. These volatile flavor components may be used alone or may be used in combination of two or more

The volatile flavor component can be adsorbed on the adsorbent. In other words, the volatile flavor component can be held on the adsorbent and can be, for example, adsorbed and held in pores of the adsorbent. Examples of the adsorbent include activated carbon, silica gel, ion exchange resin, molecular sieve, and zeolite. These adsorbents may be used alone or may be used in combination of two or more. Among these adsorbents, activated carbon is preferable from the standpoint of being capable of firmly holding the volatile flavor component. Note that, in a flavor source for the combustion-type flavor inhaler, activated carbon is not usually used because there is a possibility that carbon monoxide will be generated when activated carbon is burned.

The specific surface area of the adsorbent is preferably 500 m²/g to 3000 m²/g and more preferably 700 m²/g to 2500 m²/g in order to firmly hold the volatile flavor component. Note that the specific surface area is measured by the BET method. The amount of the volatile flavor component adsorbed on the adsorbent is preferably 1 part by mass to 20 parts by mass and more preferably 5 parts by mass to 10 parts by mass relative to 100 parts by mass of the adsorbent. The amount of the adsorbent that is included in the flavor molded body and that adsorbs the volatile flavor component is preferably 5 parts by mass to 40 parts by mass and more preferably 10 parts by mass to 30 parts by mass relative to 100 parts by mass of the tobacco powder raw material.

In the present embodiment, it is preferable that the adsorbent include a plurality of particles and that two or more of the particles be included in the flavor molded body. When two or more adsorbent particles are included in the flavor molded body, the adsorbent particles are dispersed within the flavor molded body, and the volatilization amount of the flavor component per puff is further stabilized. Although the average particle diameter of the adsorbent particles is not particularly limited, it can be, for example, 0.3 mm to 2.0 mm. Note that the average particle diameter is measured by a dry sieving method.

In the present embodiment, it is preferable that the adsorbent not be exposed at the surface of the flavor molded body. When the adsorbent is not exposed at the surface of the flavor molded body, the flavor molded body has a favorable appearance. In addition, when the flavor molded body is formed, the adsorbent such as activated carbon does not adhere to a molding machine, so that the manufacturing efficiency is improved. For example, by covering a surface of the flavor molded body that includes the adsorbent with a component of a flavor molded body that does not include an adsorbent, the flavor molded body having a surface at which no adsorbent is exposed can be obtained. Note that it can be visually confirmed that the adsorbent is not exposed at the surface of the flavor molded body.

Although the shape of the flavor molded body according to the present embodiment is not particularly limited, it can be, for example, a tablet-like shape, a plate-like shape, a cylindrical shape, a rod-like shape, a spherical shape, a hollow shape, a porous shape, or the like and is preferably a tablet-like shape for enhanced usability and strength maintenance. In the case where the flavor molded body has a tablet-like shape, the size of the tablet-shaped flavor molded body can be, for example, a diameter of 10 mm and a thickness of 6 mm.

The position of the magnet or the magnetically attracting material included in the flavor molded body is not particularly limited and the magnet or the magnetically attracting material may be disposed at the center of the interior of the flavor molded body or may be disposed on the surface of the flavor molded body. The shape of the magnet or the magnetically attracting material included in the flavor molded body is not particularly limited and can be, for example, a tablet-like shape, a plate-like shape, a cylindrical shape, a rod-like shape, a spherical shape, or the like. Although the size of the magnet or the magnetically attracting material included in the flavor molded body is not particularly limited as long as it is smaller than the flavor molded body, it can be, for example, a diameter of 6 mm and a thickness of 2 mm. The number of magnets or the number of magnetically attracting material included in the flavor molded body may be one or may be two or more.

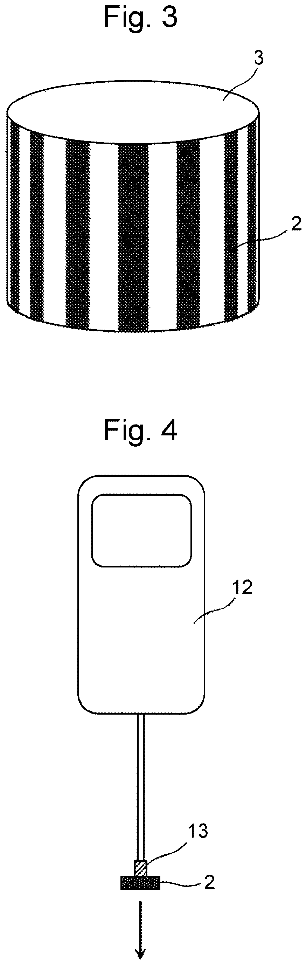

In the case where the flavor molded body has a cylindrical shape, the magnet or the magnetically attracting material included in the flavor molded body may, for example, be disposed as illustrated in Fig. 3. The flavor molded body 3 illustrated in Fig. 3 has a shape of a cylinder, and a plurality of magnets 2 are arranged in a belt-like shape in the axial direction of the cylinder on a side surface of the cylinder. The magnets 2 cause the flavor molded body 3 to be held on the heat-transmitting member, and the flavor molded body 3 can roll and move on the heat-transmitting member. As a result, the flavor molded body 3 is uniformly heated at the time of use, and residual components after use can be reduced. Note that, in the flavor molded body 3 illustrated in Fig. 3, a magnetically attracting material may be arranged instead of the magnets 2.

Although the method of manufactured the flavor molded body is not particularly limited, the flavor molded body can be manufactured by, for example, a method including the following steps: a step of mixing a tobacco powder raw material, an aerosol source, and ethanol together so as to form a mixture (hereinafter also referred to as "raw-material mixing step"), a step of placing a magnet or a magnetically attracting material in the mixture and compression-molding the mixture (hereinafter also referred to as "compression molding step"), and a step of removing at least part of the ethanol from the mixture (hereinafter also referred to as "ethanol removing step"). By the method according to the present embodiment, the flavor molded body according to the present embodiment can be efficiently and easily manufactured.

In particular, in the method according to the present embodiment, it is presumed that the addition of ethanol in the raw-material mixing step may cause a resin composition derived from the tobacco powder raw material to move to the surface of the tobacco powder raw material such that the tobacco powder raw material and other materials are bonded to each other through the resin composition, so that the flavor molded body having high strength is obtained. In addition, it is presumed that the addition of ethanol may cause some hydroxyl groups of cellulose contained in the tobacco powder raw material to undergo dehydration, resulting in condensation with neighboring cellulose, so that the flavor molded body having high strength is obtained. In this manner, in the method according to the embodiment, there is no need to use a common binding agent (binder) during molding, and most of the ethanol used is removed. Thus, it does not affect the flavor, and the flavor molded body having high strength can be obtained. Note that the ethanol removing step may be performed during or after the compression molding step as long as it is performed after the raw-material mixing step.

In the raw-material mixing step, the tobacco powder raw material, the aerosol source, and ethanol are mixed together to form the mixture. The amount of ethanol mixed is preferably 1 part by mass to 20 parts by mass relative to 100 parts by mass of the tobacco powder raw material. When the amount of ethanol mixed is 1 part by mass or more relative to 100 parts by mass of the tobacco powder raw material, the flavor molded body having higher strength can be obtained. When the amount of ethanol mixed is 20 parts by mass or less relative to 100 parts by mass of the tobacco powder raw material, the compression molding can be easily performed. In this step, the amount of ethanol mixed is more preferably 3 parts by mass to 17 parts by mass and still more preferably 5 parts by mass to 15 parts by mass relative to 100 parts by mass of the tobacco powder raw material.

In the raw-material mixing step, other components, such as cellulose powder and an adsorbent adsorbing a volatile flavor component can be further mixed in addition to the tobacco powder raw material, the aerosol source, and ethanol. In particular, cellulose powder can further enhance the strength of the flavor molded body. Although the method of mixing the raw materials is not particularly limited, they may be mixed together by, for example, using a common mixer, such as a V-type mixer.

In the compression molding step, the magnet or the magnetically attracting material is disposed in the mixture obtained through the raw-material mixing step, and the mixture undergoes compression molding. Although the machine that is used for the compression molding is not particularly limited, examples of the machine include a rotary tableting machine and the like. Although the conditions for the compression molding are not particularly limited, it is preferable to perform molding at a compression pressure of, for example, 2 kN or more. Note that, as described above, for example, at least part of the ethanol may be removed by natural drying or the like during the compression molding.

In the ethanol removing step, at least part of the ethanol is removed from the mixture. Here, as described above, the removal of at least part of the ethanol may be performed on the mixture during the compression molding step or may be performed on the molded body obtained through the compression molding step.

In the ethanol removing step, it is preferable to remove at least part of the ethanol at 10°C to 40°C. By removing at least part of the ethanol at 10°C or higher, sufficient removal of the ethanol can be performed. In addition, by removing at least part of the ethanol at 40°C or lower, the effect of heating on the flavor can be suppressed. The temperature at which at least part of the ethanol is removed is more preferably 15°C to 35°C and still more preferably 20°C to 30°C. When at least part of the ethanol is removed at 10°C to 40°C, at least part of the ethanol can be removed by, for example, drying for 30 minutes to 180 minutes at 10°C to 40°C. The removal of at least part of the ethanol can be performed by using, for example, an electric oven, hot-air drying, a tunnel dryer, or natural drying. In addition, the removal of the ethanol is preferably performed in an open space rather than a closed space.

In the ethanol removing step, 90 mass% or more of the ethanol contained in the mixture (molded body) is preferably removed, 95 mass% or more of the ethanol is more preferably removed, 99 mass% or more of the ethanol is still more preferably removed, and all the ethanol is particularly preferably removed.

### EXAMPLES

The present embodiment will be described in detail below with reference to Example below. However, the present embodiment is not limited by Example below. In Example below, the above-described magnetic force measurement method was performed as below.

### (Magnetic Force Measurement Method)

As the force gauge, FGJN-5 (product name) manufactured by Nidec-Shimpo Corporation was used. A disc member (push adapter (with a diameter of 12 mm)) made of iron was attached to the tip of a measurement part of the force gauge. The magnet used in Example was held on the disc member using magnetic force. As illustrated in Fig. 4, the force gauge 12 was fixed in position such that the magnet 2 held on a disc member 13 was positioned on the lower side, and the magnet 2 was pulled downward. A magnetic attraction force (N) when the magnet 2 is detached from the disc member was measured. The measurement was performed three times, and the average of three measured values was taken as the magnetic attraction force. The measurement was performed on the magnet that was at 20°C, the magnet that was heated to 140°C, and the magnet that was heated to 140°C and then cooled to 20°C. Note that the magnet was heated to 140°C by a method below. While the magnet was heated on a hot plate (product name: HHP-170D, manufactured by AS ONE Corporation) with a set temperature of 150°C, the temperature of the magnet was measured by placing a thermocouple on the magnet. The magnet was heated for 5 minutes, and when it was confirmed that the temperature of the magnet reached 140°C, the magnet was magnetically held onto the disc member of the force gauge, and the magnetic attraction force was measured by the above method.

### [Example 1]

### (Fabrication of Flavor Molded Body)

First, 20 parts by mass of ethanol and 20 parts by mass of glycerin were added to 100 parts by mass of a tobacco powder raw material (yellow variety raw material) having an average particle diameter of 30 µm, and they were lightly mixed with a spatula and then shaken for 30 minutes to obtain a mixture. A magnet (cylindrical (coin-shaped) neodymium magnet having a diameter of 6 mm and a thickness of 2 mm) was disposed substantially at the center of the obtained mixture, and the mixture was molded into a tablet-like shape (with a diameter of 10 mm and a thickness of 6 mm) by using a compression molding machine (trade name: TDP 0, manufactured by LFA Machines Oxford Ltd). The obtained molded body was dried at 40°C for 3 hours so as to remove the ethanol contained in the molded body, so that a flavored molded body was obtained. Note that the magnetic attraction force of the magnet at 20°C, measured by the above-described method, was 2.94 N. The magnetic attraction force of the magnet heated to 140°C, measured by the above-described method, was 0.54 N. The magnetic attraction force of the magnet heated to 140°C and then cooled to 20°C, measured by the above-described method, was 0.52 N. Accordingly, the magnetic attraction force of the magnet heated to 140°C was 18% of the magnetic attraction force of the magnet at 20°C. In addition, the magnetic attraction force of the magnet heated to 140°C and then cooled to 20°C was 17% of the magnetic attraction force of the magnet at 20°C.

### (Fabrication of Non-Combustion-Heating-Type Flavor Inhaler)

The fabricated flavor molded body 3 was introduced in the flavor molded body accommodation part 4 of the non-combustion-heating-type flavor inhaler 1 illustrated in Fig. 1. The flavor molded body 3 was held on the heat-transmitting member 8 made of iron (magnetically attracting material) using magnetic force.

### (Evaluation)

The obtained non-combustion-heating-type flavor inhaler was evaluated through actual usage. More specifically, when the first heater 6 of the non-combustion-heating-type flavor inhaler 1 illustrated in Fig. 1 was heated to 250°C, heat was sufficiently transmitted to the flavor molded body 3 through the heat-transmitting member 8, and the aerosol and the flavor component were sufficiently generated from the flavor molded body 3 and were inhaled from the mouthpiece 9. After a certain period of time has elapsed since the start of use, the magnetic force of the magnet 2 of the flavor molded body 3 was reduced, and the flavor molded body 3 was detached from the heat-transmitting member 8. Consequently, the flavor molded body 3 was easily removed after use.

### REFERENCE SIGNS LIST

- 1: non-combustion-heating-type flavor inhaler
- 2: magnet
- 3: flavor molded body
- 4: flavor molded body accommodation part
- 5: power supply unit
- 6: first heater
- 7: controller
- 8: heat-transmitting member
- 9: mouthpiece
- 10: flavor molded body collecting part
- 11: shutter
- 12: force gauge
- 13: disc member

## Claims

1. A non-combustion-heating-type flavor inhaler comprising:
a flavor molded body including a tobacco powder raw material, an aerosol source, and a magnet or a magnetically attracting material that is to be held on the magnet using magnetic force;
a flavor molded body accommodation part that accommodates the flavor molded body;
a power supply unit including a power supply;
a first heater that generates heat by receiving electric power supplied by the power supply; and
a heat-transmitting member that is provided on an inner wall of the flavor molded body accommodation part and that transmits heat from the first heater to the flavor molded body,
wherein the heat-transmitting member includes the magnetically attracting material when the flavor molded body includes the magnet, and the heat-transmitting member includes the magnet when the flavor molded body includes the magnetically attracting material, and
wherein, in a magnetic force measurement method described below, a magnetic attraction force of the magnet measured when the magnet is heated to 140°C is 95% or less of a magnetic attraction force of the magnet measured when the magnet is at 20°C.
(Magnetic Force Measurement Method)
A force gauge in which a disc member made of iron is attached to a tip of a measurement part is prepared, and a cylindrical magnet having a diameter of 6 mm and a thickness of 2 mm is held on the disc member using magnetic force. The force gauge is fixed in position such that the magnet is located on a lower side, and the magnet is pulled downward. A magnetic attraction force (N) when the magnet is detached from the disc member is measured. The measurement is performed three times, and an average of three measured values is taken as the magnetic attraction force. The measurement is performed on the magnet that is at 20°C and on the magnet that is heated to 140°C.

2. The non-combustion-heating-type flavor inhaler according to claim 1,
wherein, in the magnetic force measurement method, the magnetic attraction force of the magnet measured when the magnet is heated to 140°C is 70% or less of the magnetic attraction force of the magnet measured when the magnet is at 20°C.

3. The non-combustion-heating-type flavor inhaler according to claim 1 or 2,
wherein, when the magnetic attraction force is measured again by the magnetic force measurement method after the magnet heated to 140°C has been cooled to 20°C, the magnetic attraction force is 95% or less of the magnetic attraction force of the magnet measured when the magnet has not yet been heated and is at 20°C.

4. The non-combustion-heating-type flavor inhaler according to claim 3,
wherein, when the magnetic attraction force is measured again by the magnetic force measurement method after the magnet heated to 140°C has been cooled to 20°C, the magnetic attraction force is 70% or less of the magnetic attraction force of the magnet measured when the magnet has not yet been heated and is at 20°C.

5. The non-combustion-heating-type flavor inhaler according to any one of claims 1 to 4,
wherein the flavor molded body includes the magnet, and the heat-transmitting member includes the magnetically attracting material.

6. The non-combustion-heating-type flavor inhaler according to any one of claims 1 to 5, further comprising:
a flavor molded body collecting part that collects the flavor molded body that has been heated by the heat-transmitting member.

7. The non-combustion-heating-type flavor inhaler according to claim 6,
wherein the flavor molded body collecting part is disposed at a position facing the heat-transmitting member.

8. The non-combustion-heating-type flavor inhaler according to claim 6 or 7,
wherein the flavor molded body collecting part includes a second heater that heats the flavor molded body.
